# EUROPEAN PATENT SPECIFICATION

(11) **EP 0 917 157 B1**
(45) Date of publication and mention of the grant of the patent: **07.09.2005**
(21) Application number: 98660120.1
(22) Date of filing: 10.11.1998
(51) Int. Cl.: H01B 17/00

(54) **Insulator**
Isolator
Isolateur

(30) Priority: 12.11.1997 FI 974212
(43) Date of publication of application: 19.05.1999
(73) Proprietor: ABB Technology AG, 8050 Zürich (CH)
(72) Inventor: Rinta-Valkama, Jorma, 65350 Vaasa (FI); Rautiainen, Kari, 65100 Vaasa (FI); Viitasalo, Jukka, 65370 Vaasa (FI); Virtanen, Vesa, 65370 Vaasa (FI); Mähönen, Pentti, 65320 Vaasa (FI)
(74) Representative: Peltonen, Antti Sakari

(56) References cited:
- EP-A- 0 851 442
- DE-A- 4 435 864
- US-A- 3 942 099

## Description

### BACKGROUND OF THE INVENTION

The present invention relates to an insulator, particularly a bushing insulator comprising a primary conductor, centrally led through the body of the insulator, at least one of its ends having given external dimensions, a current measuring element disposed about the primary conductor, and at least one voltage measuring element based on voltage division and also disposed about the primary conductor.

The present invention accordingly relates to a bushing insulator, suitable for use mainly in medium voltage apparatuses. Inside the insulator are disposed sensors for measuring current and voltage, and, if required, a voltage detector. The primary conductor of a bushing insulator is conventionally made by cutting from a round copper bar a suitable piece whose one end is provided with a threaded hole, in which a pin, typically a steel pin, can be arranged for fastening the insulator to the copper rail of the apparatus, and whose other end is provided with a threaded hole for fastening a cable terminal, or alternatively a spring quick-disconnect fitting.

The external dimensions of an insulator usually have to be increased when current and voltage measuring sensors are disposed inside the insulator. This is because both the current measuring sensor and the voltage measuring sensor are typically disposed axially with respect to one another with the primary conductor passing coaxially through them. The external dimensions of the insulator have to be increased both in the diametrical and in the longitudinal direction of the insulator to be able also to arrange sufficient amounts of insulating material around these sensors. Such an apparatus is known e.g. from US Patent 4,074,193. However, it would be preferable to implement the insulator in the conventional size, whereby the sizes of the apparatuses would not have to be increased from the present, and a conventional insulator could be replaced by an insulator provided with current and voltage measuring sensors, if required, without any changes to the insulating clearances and the rest of the structure of the apparatus.

### SUMMARY OF THE INVENTION

It is an object of the present invention to provide an insulator, particularly a bushing insulator, in which the above problems are solved, i.e. an insulator provided with current and voltage measuring sensors and with external dimensions, which, however, correspond to conventional insulators which do not comprise such sensors. A primary solution to the above problem is provided by the arrangement of the invention, characterized in that the external dimensions of the primary conductor, at least at the portion surrounded by the voltage measuring element, define a substantially, e.g. at least 5%, smaller cross-sectional area than the cross-sectional area defined by the external dimensions of the primary conductor at said end thereof.

The main idea of the insulator of the invention is that at some point between the ends the diameter of the copper bar used as the primary conductor can be significantly reduced e.g. by lathe work, provided that every point in cross-sectional area of the rail remains such that the overall heating allowed for the primary conductor is not exceeded in any normal use. The end of the primary conductor is typically connected to the busbar by a pin from the threaded hole at the end of the conductor. In this case the area of the joint surface of the primary conductor is defined by the difference between the outer diameter of the primary conductor and the threaded hole provided therein, further reduced by small facets on the side of both the threaded hole and the outer edge of the primary conductor. Since the pin to be driven into the threaded hole is typically made of steel, a material with a substantially weaker electrical conductivity than that of copper, the electrical conductivity of the pin is typically ignored when determining the effective joint surface area. Since the cross-sectional area of the primary conductor between the ends does not have to be larger than said joint surface, and may be partly even smaller provided the overall heating of the primary conductor allows this, then the cross sectional area of the primary conductor can be substantially decreased between its ends, e.g. as much as 40%, without any effect on the electrical properties of the insulator. Such a smaller cross-sectional area also signifies a substantially smaller primary conductor diameter, leading, in turn, to a correspondingly smaller diameter of the voltage measuring sensor disposed about the primary conductor. Typically the distance between the primary conductor and the voltage measuring sensor is 10 mm in e.g. 24 kV bushing insulators. In other words, a smaller primary conductor diameter is immediately reflected as an identical decrease in the diameter of the voltage measuring sensor, which, in turn, is reflected in the outer diameter of the insulator.

If the insulator further comprises, for voltage identification, a second voltage measuring element displaced substantially axially to said voltage measuring element, it is preferable that the external dimensions of the primary conductor at the portion surrounded by said second voltage measuring element also define a substantially, e.g. at least 5%, smaller cross-sectional area than the cross-sectional area defined by the external dimensions of the primary conductor at said end thereof. The reduced portion of the primary conductor thus preferably covers the area of all current and voltage measuring sensors to allow a smaller outer diameter of the insulator by all sensors.

The axial length of the insulator can, in turn, be shortened by disposing the current measuring element concentrically about the voltage measuring element.

For the outer dimensions of the insulator in regard to the diameter to remain as small as possible, the diameter of the current measuring sensor also has to be as small as possible. In a known solution a Rogowski sensor, which is a toroidal coil formed from a ring-shaped bobbin, is used as the current measuring sensor, about which only one layer of enamelled copper thread is coiled. The manner of coiling requires that the toroidal core has a sufficiently large diameter and cross-sectional area to ensure a sufficiently high output voltage from the Rogowski sensor, the voltage being directly proportional to the cross-section of a single loop and the number of loops (= turns). Toroidal coiling is also slow, which increases the price of the assembly.

US Patent 4,709,205 discloses a principle according to which a Rogowski sensor can be built of separate coils, coiled about straight bobbins in the usual manner instead of toroidal coiling. The coils are arranged about the primary conductor, fastened to a printed board and series coupled electrically. Although the cross-sectional area of the innermost turns is small, enough turns can yet be arranged in the coil to ensure a sufficient output signal.

The above solution allows a Rogowski sensor in the insulator of the invention to be formed from a plurality of cylindrical coils, whereby the lengths and diameters of individual coils can be kept minimal. This again allows the Rogowski sensor to be dimensioned such that, owing to the large inner diameter, a capacitive voltage measuring sensor can be disposed therein, the outer diameter, however, remaining sufficiently small for these nested sensors to fit in a bushing insulator with a small diameter. Compared with a conventional manner of installation, the nested arrangement of the sensors according to the solution of the invention provides a short bushing insulator.

The insulator of the invention is further characterized in that the coils of said Rogowski sensor are disposed in a casing of a conductive material, comprising two halves, joined together without their cross-section forming a closed loop. On the one hand, the casing protects the sensor against effects of external electric fields, and on the other hand the sensor coils can bear against the casing so that the coils can be disposed at exactly even distances at the periphery of a circle and made to remain in place until the entire sensor has been cast in resin.

### BRIEF DESCRIPTION OF THE DRAWINGS

In the following the insulator of the invention will be described in greater detail with reference to the attached drawing, in which
Figure 1 is a side view of an exemplary embodiment of the insulator of the invention, the inner structure of the insulator being shown by dashed lines,
Figure 2 shows the insulator of Figure 1 seen in the axial direction of the insulator, and
Figure 3 shows the structure of a current measuring sensor used in the insulator of the invention, and the placement thereof in regard to the primary conductor and the voltage measuring sensor.

### DETAILED DESCRIPTION OF THE INVENTION

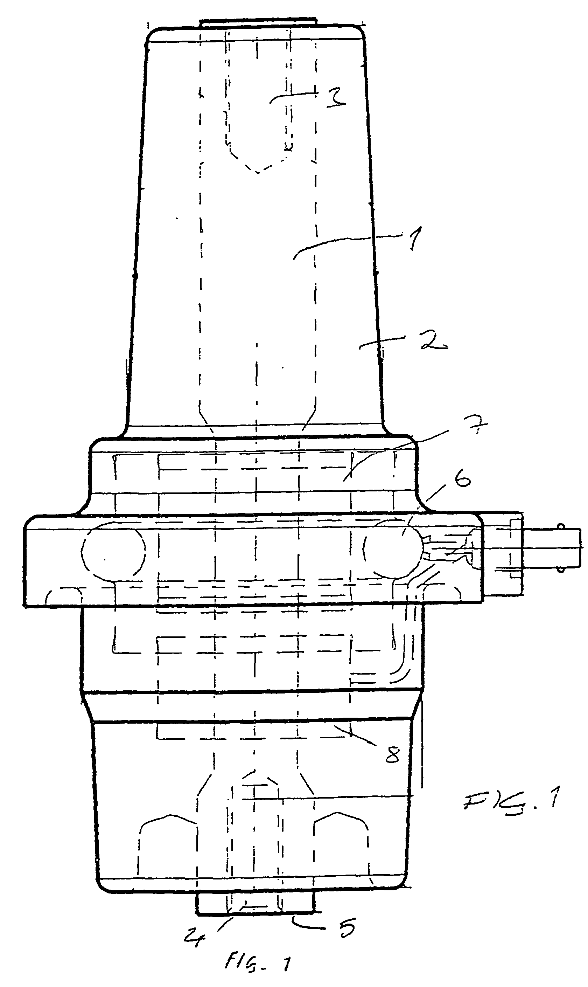

Figure 1 is a side view of an exemplary embodiment of the insulator of the invention, the inner structure of the insulator being shown by dashed lines. The insulator is longitudinal and of the shape of a body of revolution and comprises a body 2 of cast resin and a primary conductor 1 extending centrally from end to end in the axial direction. The primary conductor 1 is formed from a round copper bar, whose one end is provided with a threaded boring 4 for attachment to a copper bar by an insulator pin, typically a steel pin. In this case the second end of the primary conductor is also provided with a threaded boring 3 for coupling a cable terminal. In accordance with the invention, the diameter of the primary conductor 1 is reduced in the middle of the insulator, e.g. by lathe work, in order to make the diameters of current and voltage measuring sensors 6 to 8, disposed concentrically about said point, as small as possible.

At said point the diameter of the primary conductor 1 can be reduced by several percent, e.g. as much as 25%, whereby its cross-sectional area decreases as much as 40%. An alternative starting point in dimensioning the reduction of the primary conductor is not to allow the cross-sectional area of the primary conductor at any point to be smaller than the effective joint surface of the primary conductor. Said joint surface is defined by the difference between the outer diameter of the primary conductor 1 and the threaded hole 4, reduced by the small facets both at the edge of the threaded hole and the periphery of the end of the primary conductor. This joint surface is denoted by reference 5 in Figure 1. Provided this joint cross-sectional area remains larger than or equal to said area of the joint surface, the diameter of the primary conductor can be freely reduced, and the diameters of the sensors disposed about it can be made correspondingly so small that the outer diameter of the entire insulator remains equal to that of the insulator in which the entire length of the primary conductor has the same diameter and the insulator is not provided with current or voltage measuring sensors. If, contrary to the described embodiment, the primary conductor is widened right after the end of the primary conductor and the joint cross-section formed therein, i.e. in the case of a round primary conductor its diameter is increased, the reduced portion may even be smaller than the diameter corresponding to said joint cross-section. This is based on the fact that copper has such good heat conductivity that the portion with the extended diameter and, consequently, the portion which due to the current passing in the primary conductor is heated to a lesser degree, is able to receive heat from the portion of the primary conductor which is less heated, i.e. the reduced portion, so that the temperature evens out to an allowable level over the entire length of the primary conductor. Consequently, the total heating of the primary conductor may be the primary point to consider when assessing the maximum allowed reduction.

Figure 1 shows how a cylindrical voltage measuring sensor 7 is disposed about the primary conductor 1, the operation of the sensor being based on capacitive voltage division in a manner known per se. Axially to said voltage measuring element 7 is disposed a second voltage measuring cylinder 8, used for voltage identification. In other words, the sensor 8 is capable of detecting if the insulator is energized, and the sensor 7 serves to measure the magnitude of this voltage. The structures of said sensors are known in the art and are therefore not described in greater detail herein.

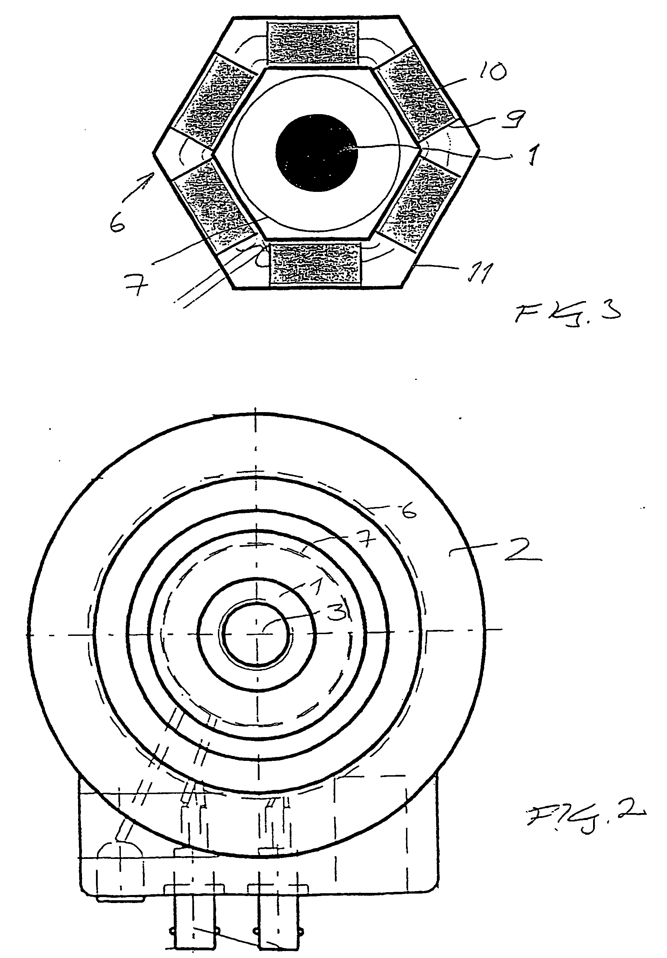

A coiling 6 of the Rogowski sensor, used as the current measuring sensor, is disposed concentrically about the voltage measuring cylinder 7. The detailed structure of said coiling is shown in Figure 3. In the embodiment described, said current measuring sensor is formed from a plurality of cylindrical coils 10, coiled on separate bobbins 9 and disposed in the same plane, perpendicular to the axial direction of the insulator, in the shape of a polygon and with their coils coupled in series. The operating principle of such a Rogowski sensor has been described above and is also disclosed in said US Patent 4,709,205 and in French Patent 2507811. The operating principle of the sensor is therefore not described in any greater detail herein. As is evident from Figure 3, the Rogowski sensor 6 comprises six coils 10 arranged in the shape of a hexagon. In the insulator of the invention, the coils 10 constituting the Rogowski sensor are disposed in a protective casing 11 made of thin aluminium to attenuate interference caused by external electric fields. This protective casing 11 is preferably built of two halves and shaped so that the coils 10 are disposed at exactly even distances at the periphery of a circle and remain in place until the entire sensor has been cast in resin. The halves of the protective casing 11 are so designed that the cross-section of the casing is not a closed loop. This would inhibit the operation of the sensor since the field would not be able to enter the sensor and generate in the sensor coils the voltage required in current measurement.

A very compact size is an advantage of the insulator of the invention, and, as mentioned above, the size of the bushing insulator of the invention, provided with sensors, can be the same as that of a conventional bushing insulator with no sensors. This makes it possible to replace an installed conventional bushing insulator with the bushing insulator of the invention, provided with sensors, if required. Small size and light weight also cause savings in manufacturing and freight costs. Furthermore, the structure of the Rogowski sensor is advantageous in manufacture compared with conventional toroidal coiling. The only drawback in the bushing insulator of the invention is one extra stage of operation in the processing of the copper bar constituting the primary conductor. However, the extra stage can be easily combined with the boring of the threaded holes in the rail.

The positioning of the coils of the Rogowski sensor employed in the insulator of the invention is important e.g. to minimize the error caused by adjacent phases in the measurement result. The Rogowski sensor coils can also be positioned by placing in the aluminium casing a fitting piece cast of plastic, by means of which the coils are disposed at even distances.

The insulator of the invention has been described above by means of only one exemplary embodiment and it is to be understood that modifications can be made thereto without, however, deviating from the scope defined by the attached claims.

## Claims

1. An insulator, particularly a bushing insulator comprising a primary conductor (1), centrally led through the body (2) of the insulator, at least one of its ends having given external dimensions, a current measuring element (6) disposed about the primary conductor, and at least one voltage measuring element (7) based on voltage division and also disposed about the primary conductor, **characterized in that** the external dimensions of the primary conductor (1), at least at the portion surrounded by the voltage measuring element (7), define a substantially, i.e. at least 5%, smaller cross-sectional area than the cross-sectional area defined by the external dimensions of the primary conductor at said end thereof.

2. An insulator as claimed in claim 1, **characterized in that** for voltage identification, the insulator further comprises a second voltage measuring element (8) displaced substantially axially to said voltage measuring element (7) and that the external dimensions of the primary conductor (1) at the portion surrounded by said second voltage measuring element (8) also define a substantially, i.e. at least 5%, smaller cross-sectional area than the cross-sectional area defined by the external dimensions of the primary conductor at said end thereof.

3. An insulator as claimed in claim 1, **characterized in that** the current measuring element (6) is disposed concentrically about the voltage measuring element (7).

4. An insulator as claimed in claim 1, the current measuring element (6) being a Rogowski sensor, **characterized in that** the Rogowski sensor comprises a plurality of series-coupled coils (10) disposed about the primary conductor (1) of the insulator and coiled on bobbins (9) arranged in the shape of a polygon in a plane perpendicular to the axial direction of the insulator.

5. An insulator as claimed in claim 4, **characterized in that** the coils of the Rogowski sensor are disposed in a casing (11) made of a conductive material and comprising two halves, joined together without their cross-section forming a closed loop.

## Patentansprüche

1. Ein Isolator, insbesondere ein Muffenisolator, mit einem Primärleiter (1), der mittig durch den Körper (2) des Isolators geführt ist, wobei wenigstens eines seiner Enden gegebene äußere Abmessungen hat, wobei ein Strommesselement (6) um den Primärleiter herum angeordnet ist und wenigstens ein Spannungsmesselement (7), welches auf Spannungsteilung basiert, ebenfalls um den Primärleiter herum angeordnet ist, **dadurch gekennzeichnet, dass** die Außenabmessungen des Primärleiters (1) wenigstens an dem Abschnitt, der von dem Spannungsmesselement (7) umgeben ist, eine wesentlich, d.h. mindestens 5 % kleinere Querschnittsfläche als die Querschnittsfläche definiert, welche von den Außenabmessungen des Primärleiters an seinem Ende hiervon definiert ist.

2. Ein Isolator nach Anspruch 1, **dadurch gekennzeichnet, dass** zur Spannungsidentifikation der Isolator weiterhin ein zweites Spannungsmesselement (8) aufweist, welches im Wesentlichen axial zu dem Spannungsmesselement (7) angeordnet ist, wobei die Außenabmessungen des Primärleiters (1) an den Abschnitten, welche von dem zweiten Spannungsmesselement (8) umgeben sind, ebenfalls eine wesentlich, d.h. mindestens 5 % kleinere Querschnittsfläche als die Querschnittsfläche definieren, welche durch die Außenabmessungen des Primärleiters an dem Ende hiervon definiert ist.

3. Ein Isolator nach Anspruch 1, **dadurch gekennzeichnet, dass** das Strommesselement (6) konzentrisch um das Spannungsmesselement (7) herum angeordnet ist.

4. Ein Isolator nach Anspruch 1, wobei das Strommesselement (6) ein Rogowski-Sensor ist, **dadurch gekennzeichnet, dass** der Rogowski-Sensor eine Mehrzahl von in Serie verbundenen Spulen (10) aufweist, welche um den Primärleiter (1) des Isolators herum angeordnet sind und auf Kerne (9) gewickelt sind, welche in Form eines Polygons in einer Ebene senkrecht zur Axialrichtung des Isolators angeordnet sind.

5. Ein Isolator nach Anspruch 4, **dadurch gekennzeichnet, dass** die Spulen des Rogowski-Sensors in einem Gehäuse (11) aus leitfähigem Material bestehend aus zwei Hälften angeordnet sind, welche zusammengefügt sind, ohne dass ihr Querschnitt eine geschlossene Hülle bildet.

## Revendications

1. Un isolateur, en particulier un isolateur en forme de douille comprenant un conducteur primaire (1), disposé d'une manière centrale dans le corps (2) de l'isolateur, au moins une de ses extrémités ayant des dimensions externes définies, un élément de mesure de courant (6) placé sur le conducteur primaire, et au moins un élément de mesure de tension (7) basé sur le principe d'un diviseur de tension et également placé sur le conducteur primaire, **caractérisé en ce que** les dimensions externes du conducteur primaire (1), au moins pour ce qui concerne la partie entourée par l'élément de mesure de tension (7), définissent sensiblement, c'est à dire au moins de 5%, une plus petite section que la section définie par les dimensions externes du conducteur primaire à ladite extrémité.

2. Un isolateur selon la revendication 1, **caractérisé en ce que** pour la mesure de tension, l'isolateur comprend en outre un deuxième élément de mesure de la tension (8) placé essentiellement axialement par rapport au dit élément de mesure de tension (7) et que les dimensions externes du conducteur primaire (1) à la partie entourant l'élément de mesure de ladite deuxième tension (8) définissent également sensiblement, c'est à dire au moins 5%, une plus petite section que la section définie par les dimensions externes du conducteur primaire à ladite extrémité.

3. Un isolateur selon la revendication 1, **caractérisé en ce que** l'élément de mesure de courant (6) est disposé concentriquement à l'élément de mesure de tension (7).

4. Un isolateur selon la revendication 1, l'élément de mesure de courant (6) étant un capteur de Rogowski, **caractérisé en ce que** le capteur de Rogowski comporte une pluralité d'enroulements couplés en série (10) placés sur le conducteur primaire (1) de l'isolateur et enroulés sur des bobines (9) disposés suivant un polygone situé dans un plan perpendiculaire à la direction axiale de l'isolateur.

5. Un isolateur selon la revendication 4, **caractérisé en ce que** les enroulements du capteur de Rogowski sont disposés dans une enveloppe (11) constituée d'un matériau conducteur et comprenant deux moitiés, jointes ensemble sans que leur section transversale ne forme une boucle fermée.
